# EUROPEAN PATENT APPLICATION

(11) **EP 3 162 561 A1**
(43) Date of publication of application: **03.05.2017**
(21) Application number: 14752247.8
(22) Date of filing: 10.06.2014
(51) Int. Cl.: B32B 27/08

(54) **THERMOSET RESIN SANDWICHED PRE-PREG BODY, MANUFACTURING METHOD AND COPPER CLAD PLATE**

(30) Priority: 27.05.2014 CN 201410227876
(71) Applicant: Shengyi Technology Co., Ltd., 523000 Dongguan City Guangdong (CN)
(72) Inventor: CHAI, Songgang, Dongguan City, Guangdong 523808 (CN)
(74) Representative: Ricker, Mathias
(86) International application number: PCT/CN2014/079599
(87) International publication number: WO 2015/180206

(57) **Abstract**

The present invention relates to a thermosetting resin sandwich prepreg, and the copper clad laminates and multi-layered printed circuit wiring boards manufactured therefrom. The interlayer of the thermosetting resin sandwich prepreg contains the thermosetting resin composition with a high content of fillers, and the outer layer of the prepreg contains the thermosetting resin composition with a low content of fillers. The copper clad laminates prepared by using the prepregs have good adhesion to metal foils, insulativity and uniform dielectric constant distribution.

## Description

### Technical field

The present invention relates to a thermosetting resin composition, and the copper clad laminates and printed circuit boards manufactured therefrom.

### Background art

The requirement of lead-free environmental protection for electronic industry promotes the application of fillers in copper clad laminate industry. Use of packing technology has been an important approach to enhance performances of copper clad laminates. The development tendency of how fillers are applied in copper clad laminate industry is the constant increase in the content of fillers. The ratio of fillers in a high content brings more excellent performances such as decreased thermal expansion coefficient, increased thermal conductivity and enhanced intensity, etc.

As the surface of the fillers is inert, the increase in the content of fillers may lead to the decrease of adhesive force between metal foils and thermosetting resin compositions. Patent CN101973145 improves the adhesion between thermosetting resins with fillers in a high content and metal foils by coating the metal foils with varnish. In the laid-open patent 2009-127014 of Japan Matsushita Electric Works, the application of thermosetting resin varnish solutions containing different contents of inorganic fillers on the both sides of a prepreg is put forwards. On the side close to the conductive layer of the prepreg, varnish solutions with a low content of inorganic filler are coated to increase the adhesion with metal foils. However, the two ways above both require special coating equipments, thereby increasing the cost of production.

Accordingly, in the art there exists a need for finding better solutions to solve the problems above.

### Summary of the invention

Directing to the technical problems to be solved by the present invention, one of the objects of the present invention lies in providing a thermosetting resin sandwich prepreg. The thermosetting resin sandwich prepreg is consisting of an interlayer and outer layers cladded on the both sides of the interlayer. The interlayer contains a thermosetting resin composition with a high content of fillers, and the outer layer contains a thermosetting resin composition with a low content of fillers. The copper clad laminates prepared by using the prepregs have good adhesion to metal foils, good insulativity and uniform dielectric constant distribution.

In an embodiment, the inter layer of the thermosetting resin sandwich prepreg includes 20-80% by weight of a fillers, 20-70% by weight of a reinforcing material, 0-30% by weight of a thermosetting resin (the fillers + the reinforcing material + the thermosetting resin totaling 100 % by weight); the outer layer of the prepreg includes 0-20% by weight of a fillers, 20-80% by weight of a thermosetting resin (the fillers + the thermosetting resin totaling 100% by weight).

In an embodiment, the reinforcing material is an inorganic or organic material. The inorganic material is a machine-woven fabric or non-woven fabric or paper of a glass fiber, carbon fiber, boron fiber, or metal, in which the glass fiber fabric or non-woven fabric is E-glass, Q-type fabric, NE fabric, D-type fabric, S-type fabric or high silica fabric; the organic material is a woven fabric or non-woven fabric or paper manufactured from polyesters, polyamines, polyacrylic acids, polyimides, aramid fiber, polytetrafluoroethylene, or syndiotactic polystyrenes.

In yet another embodiment, the fillers is one or more selected from crystalline silica, fused silica, spherical silica, aluminum hydroxide, calcium carbonate, strontium titanate, barium titanate, barium strontium titanate, boron nitride, aluminum nitride, silicon carbide, aluminum oxide, titanium dioxide, glass powder, glass chopped fiber, talc powder, mica powder, carbon black, carbon nanotube, graphene, metal powder, zinc molybdate, polyphenylene sulfide, and PTFE powder. The moderate value of the particle size of the powder fillers is 0.01~15µm; preferably, the moderate value of the particle size of the powder fillers is 0.5~10µm.

In a preferred embodiment, the glass fiber fabric is E-type glass fiber fabric, Dk of the corresponding fillers is 6.0~6.6, the fillers is selected from E-glass powder; in another preferred embodiment, the glass fiber fabric is NE-type glass fiber fabric, Dk of the corresponding fillers is 4.4~4.6, the fillers is selected from NE glass powder.

In yet another embodiment, the thermosetting resin includes: one or more selected from epoxy resin, cyanate resin, phenolic aldehyde resin, polyphenyl ether resin, polybutadiene resin, polybutadiene-styrene copolymer resin, polytetrafluoroethylene resin, polybenzoxazine resin, polyimide, silicon-containing resin, bismaleimide triazine resin (BT resin), LCP(Liquid Crystal Polymer) resin and bismaleimide resin.

In another embodiment, the thickness of the outer layer of the prepreg is 1~100µm; preferably, the thickness of the outer layer of the prepreg is 5~50µm.

Another object of the present invention lies in providing a preparation method for manufacturing the sandwich prepreg of the present invention, which is characterized in the following steps:
Step 1: impregnating the reinforcing material with a thermosetting resin varnish solution having a fillers content of 40-100% by weight (said % by weight is the content of solid ingredients in the thermosetting resin varnish solution, solvent excluded), and obtaining the prepreg interlayer.
Step 2: further impregnating the prepreg inter layer obtained in step 1 with a thermosetting resin varnish solution having a fillers content of 0-30% by weight, and preparing the sandwich prepreg.

In a preferred embodiment, the fillers content in the thermosetting resin varnish solution impregnated in the step 2 above is 0-20%.

In another preferred embodiment, the sandwich prepreg is prepared by a vertical or horizontal type impregnation machine.

Another object of the present invention lies in providing copper clad laminates prepared from the sandwich prepreg of the present invention.

In an embodiment, the copper clad laminate includes: prepregs, and copper foils cladded on both sides of the prepregs. The prepreg includes the reinforcing material and the thermosetting resin composition adhered thereon by impregnation and drying.

In a preferred embodiment, the reinforcing material is an inorganic or organic material. The inorganic material is a machine-woven fabric or non-woven fabric or paper of a glass fiber, carbon fiber, boron fiber, or metal, in which the glass fiber fabric or non-woven fabric is E-glass, Q-type fabric, NE fabric, D-type fabric, S-type fabric or high silica fabric; the organic material is a woven fabric or non-woven fabric or paper manufactured from polyesters, polyamines, poly acrylic acids, polyimides, aramid fiber, polytetrafluoroethylene, or syndiotactic polystyrenes; the metal foils are foils of copper, brass, aluminum, nickel, or alloys or composite metals of these metals. The thickness of the metal foil is 12-150µm.

Compared to the prior art, the present invention has the following advantage effects:
(1) in the thermosetting resin sandwich prepreg employed by the present invention, the inter layer thereof contains a thermosetting resin composition with a high fillers content and the outer layer thereof contains a thermosetting resin composition with a low fillers content, thereby enhancing the adhesion between the prepreg outer layers and metal foils.
(2)in the thermosetting resin sandwich prepreg employed by the present invention, the fillers is concentrated intermediately, the outer layers are protected by the thermosetting resin with excellent insulativity, and therefore able to enhance the insulativity of the prepreg. Resulting from the protection of the outer-layered thermosetting resin layer, in the copper clad laminates of the present invention can be used fillers with poor insulativity, like metal powders, carbon series powders; also can be used fillers with poor chemical resistance, like calcium carbonate, aluminum hydroxide.
(3) Meanwhile, in the sandwich prepreg employed by the present invention, the fillers is concentrated in the interlayer, thus increasing the uniformity of the copper clad laminates in horizontal direction, and improving the uniformity of the dielectric constant of the copper clad laminates.

### Brief description of the drawing

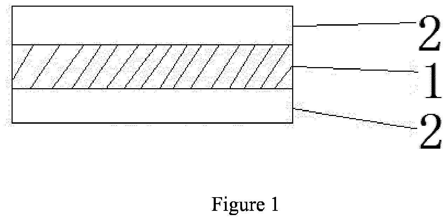

Figure 1 is a structural schematic diagram of the thermosetting resin sandwich prepreg of the present invention. 1 denotes the interlayer, and 2 denote the outer layers.

### Embodiments

The "Dk" as used herein refers to a dielectric constant; a value measured at 10GHz with SPDR method.

The "Df" as used herein refers to a dielectric loss; a value measured at 10GHz with SPDR method.

The resin composition as used herein is a composition including a resin and a curing agent. For example, an epoxy resin composition is a composition including an epoxy resin and a suitable curing agent. Those skilled in the art are able to select a suitable curing agent and the content thereof according to the resin used, and able to select a suitable organic solvent according to the resin and curing agent used.

In accordance with the present invention, the thermosetting resin includes: one or more selected from epoxy resin, cyanate resin, phenolic aldehyde resin, polyphenyl ether resin, polybutadiene resin, polybutadiene-styrene copolymer resin, polytetrafluoroethylene resin, polybenzoxazine resin, polyimide, silicon-containing resin, bismaleimide triazine resin (BT resin), LCP (Liquid Crystal Polymer) resin and bismaleimide resin.

The fillers as used herein refers to a fillers material, fillers for short. The purpose of using fillers in copper clad laminate industry is not only for lowering cost merely, but also for enhancing the performances of copper clad laminates such as a decrease in CTE, an increase in fire retardancy and enhancements in heat conductivity coefficient and mechanical properties of boards, etc.

According to the present invention, the fillers is one or more selected from crystalline silica, fused silica, spherical silica, aluminum hydroxide, calcium carbonate, strontium titanate, barium titanate, barium strontium titanate, boron nitride, aluminum nitride, silicon carbide, aluminum oxide, titanium dioxide, glass powder, glass chopped fiber, talc powder, mica powder, carbon black, carbon nanotube, graphene, metal powder, zinc molybdate, polyphenylene sulfide, and PTFE powder. The moderate value of the particle size of the powder fillers is 0.01~15µm; preferably, the moderate value of the particle size of the powder fillers is 0.5~10µm.

The glue solution used in the present invention refers to the glue solution by dissolving the resin composition of the present invention in a suitable organic solvent. Preferably, the glue solution used in the present invention refers to the dispersion system obtained by dissolving the resin composition of the present invention in a suitable organic solvent and then adding a fillers. Those skilled in the art can allow the pretreated glue solution have a suitable dielectric constant (Dk) by adjusting the content of the fillers in the pretreated glue solution. In the present invention, a Dk of the varnish solution is the Dk of dry varnish after removing solvent from the glue solution. The value is only related to the contents of the resin composition and fillers, and unrelated to the content of solvent.

The impregnation used in the present invention refers to the operation of impregnating the glass fiber fabric into the varnish solution, and then drying off the solvent by a gluing machine.

According to the present invention, the resin with a high fillers content has a Dk which is equivalent to the Dk of the reinforcing material layer used ±30%, preferably the Dk of the reinforcing material layer used±20%, more preferably the Dk of the reinforcing material layer used ± 10%. The closer the Dk gets to the Dk of glass fiber fabric, the difference of dielectric constant between X and Y direction is smaller, and the signal delay is smaller.

According to the present invention, the reinforcing material is an inorganic or organic material. The organic material is a machine-woven fabric or non-woven fabric or paper of a glass fiber, carbon fiber, boron fiber, or metal, in which the glass fiber fabric or non-woven fabric is E-glass, Q-type fabric, NE fabric, D-type fabric, S-type fabric or high silica fabric; the organic material is a woven fabric or non-woven fabric or paper manufactured from polyesters, polyamines, poly acrylic acids, polyimides, aramid fiber, polytetrafluoroethylene, or syndiotactic polystyrenes.

According to the present invention, when the reinforcing material layer is E-type glass fiber fabric, the Dk(10GHz) of the glue solution with a high content of fillers is selected to be within 6.0~6.6.

According to the present invention, when the reinforcing material layer is NE-type glass fiber fabric, the Dk(10GHz) of the varnish solution with a high content of fillers is selected to be within 4.4~4.6.

### Examples

For the purpose of understanding the present invention, examples are listed by the present invention as follows. It should be understood by those skilled in the art that the examples are helpful to understand the present invention only, and should not be regarded as specific limitations to the present invention.

Each designation and the component thereof used in the examples and comparative examples are as follows:
Thermosetting resin A:represents novolac epoxy resin produced by Hexion Specialty Chemicals, Inc., America (former America Borden Chemicals, Inc. and Germany Bakelite AG). The trade name is EPR627-MEK80 and the epoxy equivalent is between 160~250g/eq.
Thermosetting resin B: represents bisphenol A-type cyanate prepolymer produced by Shanghai Huifeng Company. The trade name is HF-10.

The curing agent represents phenolic aldehyde resin curing agent produced by Hexion Specialty Chemicals, Inc., America. The trade name is PHL6635M65.

The accelerator represents 2MI produced by Japan Shikoku Chemicals Co. Ltd.
Fillers A represents barium titanate from Shandong Sinocera Functional Material Co., Ltd. The trade name is BT 300.
Fillers B represents composite silicon micro powder from Lianyungang Donghai silica powder Co. Ltd. The trade name is DB1003 with an average particle size of 2-3 micrometer.
Fillers C represents carbon black powder produced by Germany Degussa AG. The trade name is FW200.

The reinforcing material layer is E-glass fabric with a Dk of 6.6.

### Examples 1-4

The solid ingredients of examples 1-4 are detailedly shown in tableland formulated with butanone into the thermosetting epoxy resin varnish used in manufacturing copper clad laminates, wherein the solid ingredients accounted for 65%.

The copper foil clad substrates of examples 1-4 is prepared according to the following preparation process:
(1) Varnish preparation: the solvent was added into an formulating container and the thermosetting rein, curing agent solution and curing accelerator were added under stirring; after two hours of stirring, the fillers was added. After proceeding with stirring for 4-8 hours, samples were taken and the gelling time of the glue solution (170°C thermostatic heating plate) was measured as 200~300 seconds.
(2) Impregnation: the reinforcing material layer impregnated with glue solution 1 and glue solution 2 respectively was passed through a vertical or horizontal type impregnation machine. The sandwich prepreg was obtained by controlling conditions of extrusion wheel speed, linear speed, aeration temperature and furnace temperature.
(3) Pressing: after combining the clipped sandwich prepregs with copper foils, they were put into a vacuum hot press and the copper foil clad laminates were finally prepared according to certain temperature, time and pressure. The specific example is:
   Temperature procedure: 130 °C /30min+155 °C /30min+190 °C /90min+220°C/60min;
   Pressure procedure: 25Kgf.cm-2/30min+50Kgf.cm-2/30min+90Kgf.cm-2/120min+30Kgf.cm-2/90min;
   Vacuum procedure: 30mmHg/130min+800mmHg/130min.

Via the procedures above, 8prepregs with a thickness of 0.2mm were employed to laminate by layers between the 35µm-thick copper foils. After hot-pressing, the 1.6mm-thick copper clad laminates were prepared. After obtaining the copper clad laminates, the performance of the laminates was tested. Comparisons between performance of laminates are as shown in table 3.

**Table 1**

| componen t | 1 | | 2 | | 3 | | 4 | |
|---|---|---|---|---|---|---|---|---|
| | Varnis h solution1 | Varni sh solution 2 | Varni sh solution 1 | Varni sh solution 2 | Varni sh solution 1 | Varni sh solution 2 | Varni sh solution 1 | Varni sh solution 2 |
| Thermose tting resin A/g | 0 | 70 | 50 | 50 | 70 | 70 | 70 | 70 |
| Thermose tting resin B/g | 0 | 0 | 50 | 50 | 0 | 0 | 0 | 0 |
| Curing agent/g | 0 | 30 | 0 | 0 | 30 | 30 | 30 | 30 |
| accelerato r/g | 0 | 0.05 | 0.05 | 0.05 | 0.05 | 0.05 | 0.05 | 0.05 |
| Fillers A/g | -- | -- | 100 | -- | -- | -- | 100 | 20 |
| Fillers B/g | 100 | -- | -- | -- | -- | -- | -- | -- |
| Fillers C/g | -- | -- | -- | -- | 30 | -- | -- | -- |
| Dk of glue solution | 6.0 | -- | 6.0 | -- | 6.5 | -- | 6.2 | -- |

### Comparative examples 1-3

The solid ingredients of comparative examples 1-3 are detailedly shown in table2 and formulated with butanone into the thermosetting epoxy resin varnish solution used in manufacturing copper clad laminates, wherein the solid ingredients accounted for 65%.The preparation method of comparative examples 1-3 is as follows:
(1) Varnish preparation: the solvent was added into an formulating container and the thermosetting rein, curing agent solution and curing accelerator were added under stirring; after two hours of stirring, the fillers was added. After proceeding with stirring for 4-8 hours, samples were taken and the gelling time of the varnish solution (170 °C thermostatic heating plate) was measured as 200~300 seconds.
(2) Impregnation: the reinforcing material layer impregnated with varnish solution was passed through a vertical or horizontal type impregnation machine. The sandwich prepreg was obtained by controlling conditions of extrusion wheel speed, linear speed, aeration temperature and furnace temperature.
(3) Pressing: after combining the clipped sandwich prepregs with copper foils, they were put into a vacuum hot press and the copper foil clad laminates were finally prepared according to certain temperature, time and pressure. The specific example is:
   Temperature procedure: 130 °C /30min+155 °C /30min+190 °C /90min+220°C/60min;
   Pressure procedure: 25Kgf.cm-2/30min+50Kgf.cm-2/30min+90Kgf.cm-2/120min+30Kgf.cm-2/90min;
   Vacuum procedure: 30mmHg/130min+800mmHg/130min.

Via the procedures above, 8prepregs with a thickness of 0.2mm were employed to laminate by layers between the 35µm-thick copper foils. After hot-pressing, the 1.6mm-thick copper clad laminates were prepared.

**Table 2**

| component | Comparative example | | |
|---|---|---|---|
| | 1 | 2 | 3 |
| Thermosetting resin A/g | 70 | 50 | 70 |
| Thermosetting resin B/g | 0 | 50 | 0 |
| Curing agent/g | 30 | 0 | 30 |
| accelerator/g | 0.05 | 0.05 | 0.05 |
| Fillers A/g | -- | 33 | -- |
| Fillers B/g | 100 | -- | -- |
| Fillers C/g | -- | -- | 50 |
| Dk of varnish solution | 4.6 | 5.0 | 7.5 |

The following methods were employed to measure the volume resistivity and electric resistance of the copper foil clad substrates prepared by examples 1-4 and comparative examples 1-3. The tested results are shown as table 3.

**Table 3**

| Tested item | Example | | | | Comparative example | | |
|---|---|---|---|---|---|---|---|
| | 1 | 2 | 3 | 4 | 1 | 2 | 3 |
| peel strength (N/mm) | 1.6 | 1.5 | 1.8 | 1.7 | 0.8 | 1.0 | 1.2 |
| volume resistivity (MΩ·cm) | 4.2×10⁸ | 4.0×10⁸ | 4.2×10⁸ | 4.2×10⁸ | 4.0×10⁸ | 4.0×10⁸ | <10⁴ |
| Dk of circuit substrates | 5.0 | 6.0 | 6.5 | 6.6 | 5.0 | 6.0 | 6.6 |
| Warp signal delay/ps | 10 | 9 | 8 | 7 | 35 | 38 | 47 |
| Weft signal delay/ps | 9 | 8 | 7 | 7 | 16 | 18 | 17 |

It can be known from table3, the sandwich structure prepared by specific process using the copper foil clad substrate of the present invention has better adhesion compared to the comparative examples. As shown in example 3, when using a conductive fillers, the copper foil clad substrate of the present invention still has a good insulativity due to the protection by the outer insulative layers; correspondingly comparative example 3 employed a traditional process, and the insulativity can not meet the requirements. Meanwhile, the copper foil clad substrate of the present invention has a more uniform dielectric constant compared to the comparative examples, thus the problem of signal delay acquires a great improvement.

The examples above do not make any limitation to the content of the composition of the present invention. All the slight amendments, equivalent changes and modifications according to the technical essence, components or contents of the composition of the present invention, fall into the scope of the technical solution of the present invention.

## Claims

1. A thermosetting resin sandwich prepreg, which is consisting of an interlayer and outer layers cladded on the both sides of the interlayer; the interlayer includes 20-80% by weight of a fillers, 20-70% by weight of a reinforcing material, 0-30% by weight of a thermosetting resin, based on the fillers + the reinforcing material + the thermosetting resin totaling 100 % by weight; the outer layer includes 0-20% by weight of a fillers and 20-80% by weight of a thermosetting resin, based on the fillers + the thermosetting resin totaling 100% by weight.

2. The sandwich prepreg according to claim 1, which is **characterized in that**, the fillers is one or more selected from crystalline silica, fused silica, spherical silica, aluminum hydroxide, calcium carbonate, strontium titanate, barium titanate, barium strontium titanate, boron nitride, aluminum nitride, silicon carbide, aluminum oxide, titanium dioxide, glass powder, glass chopped fiber, talc powder, mica powder, carbon black, carbon nanotube, graphene, metal powder, zinc molybdate, polyphenylene sulfide, and PTFE powder; the moderate value of the particle size of the powder fillers is 0.01~15µm; preferably, the moderate value of the particle size of the powder fillers is 0.5~10µm.

3. The sandwich prepreg according to claim 1 or 2, which is **characterized in that**, the thickness of the outer layer of the prepreg is 1~100µm; preferably, the thickness of the outer layer of the prepreg is 5~50µm.

4. The sandwich prepreg according to any one of claims 1-3, which is **characterized in that**, the thermosetting resin includes: one or more selected from epoxy resin, cyanate resin, phenolic aldehyde resin, polyphenyl ether resin, polybutadiene resin, polybutadiene-styrene copolymer resin, polytetrafluoroethylene resin, polybenzoxazine resin, polyimide, silicon-containing resin, bismaleimide triazine resin (BT resin), LCP (Liquid Crystal Polymer) resin and bismaleimide resin.

5. The sandwich prepreg according to any one of claims 1-4, which is **characterized in that**, the reinforcing material fabric is E-type glass fiber fabric or NE-type glass fiber fabric; Dk of a varnish solution prepared with a thermosetting resin and the fillers corresponding to the interlayer using E-type glass fiber fabric is 6.0~6.6; Dk of a varnish solution prepared with a thermosetting resin and the fillers corresponding to the interlayer using NE-type glass fiber fabric is 4.4~4.6; preferably, Dk of the fillers in the interlayer using E-type glass fiber fabric is 6.0~6.6, the fillers is selected from E-glass powder; Dk of the fillers in the interlayer using NE-type glass fiber fabric is 4.4~4.6, the fillers is selected from NE glass powder.

6. A preparation method for manufacturing the sandwich prepreg according to any one of claims 1-5, which is **characterized in** the following steps:
Step 1: impregnating 20-70% by weight of the reinforcing material with the thermosetting resin varnish solution containing 20-80% by weight of the fillers, 0-30% by weight of the thermosetting resin, based on the fillers + the reinforcing material + the thermosetting resin totaling 100 % by weight, and obtaining the prepreg;
Step 2: further impregnating the prepreg obtained in step 1 with the thermosetting resin varnish solution containing a fillers content of 0-30% based on the fillers + the thermosetting resin totaling 100% by weight, and preparing the sandwich prepreg.

7. The preparation method according to claim 6, which is **characterized in that**, the glass fiber fabric is E-type glass fiber fabric, Dk of the corresponding fillers is 6.0~6.6, the fillers is selected from E-glass powder; preferably, the glass fiber fabric is NE-type glass fiber fabric, Dk of the corresponding fillers is 4.4~4.6, the fillers is selected from NE glass powder.

8. The preparation method according to claims 6 or 7, which is **characterized in that**, the sandwich prepreg is prepared by a vertical or horizontal type impregnation machine.

9. A copper clad laminate manufactured with the sandwich prepreg according to any one of claims 1-5, which is **characterized in** including:
prepregs, and copper foils cladded on both sides of the prepregs; the prepreg includes the reinforcing material and the thermosetting resin composition adhered thereon by impregnation and drying.

10. The copper clad laminate according to claim 9, which is **characterized in that**, the reinforcing material is an inorganic or organic material; the inorganic material is a machine-woven fabric or non-woven fabric or paper of a glass fiber, carbon fiber, boron fiber, or metal, in which the glass fiber fabric or non-woven fabric is E-glass, Q-type fabric, NE fabric, D-type fabric, S-type fabric or high silica fabric; the organic material is a woven fabric or non-woven fabric or paper manufactured from polyesters, polyamines, poly acrylic acids, polyimides, aramid fiber, polytetrafluoroethylene, or syndiotactic polystyrenes; the metal foils are foils of copper, brass, aluminum, nickel, or alloys or composite metals of these metals; the thickness of the metal foil is 12-150µm.
